# FASCICULE DE BREVET EUROPEEN

(11) **EP 3 453 787 B1**
(45) Date de publication et mention de la délivrance du brevet: **19.02.2020**
(21) Numéro de dépôt: 17190410.5
(22) Date de dépôt: 11.09.2017
(51) Int. Cl.: C25D 5/02, B81C 99/00, G03F 7/00

(54) **PROCEDE DE FABRICATION D'UN LOT DE PIECES DE MICROMECANIQUE MULTI-NIVEAU EN METAL**
HERSTELLUNGSVERFAHREN EINES LOSES VON MEHRSTUFIGEN MIKROMECHANISCHEN METALLTEILEN
METHOD FOR MANUFACTURING A BATCH OF MULTI-LEVEL MICROMECHANICAL METAL PARTS

(43) Date de publication de la demande: 13.03.2019
(73) Titulaire: Patek Philippe SA Genève, 1204 Genève (CH)
(72) Inventeur: GUILLOT, Laurent, 25300 Pontarlier (FR); JEANNERET, Sylvain, 2013 Colombier (CH)
(74) Mandataire: Micheli & Cie SA

(56) Documents cités:
- EP-A1- 2 309 342
- EP-A2- 2 767 870
- CH-B1- 705 433
- US-A1- 2005 088 193

## Description

La présente invention concerne un procédé de fabrication par lots de pièces de micromécanique en métal, le procédé associant une technologie de type LIGA à au moins une étape d'usinage mécanique.

### ART ANTERIEUR

Les pièces de micromécanique obtenues par la plupart des procédés de galvanoplastie connus doivent être retouchées après coup. Le travail de retouche s'avère le plus souvent tout à la fois fastidieux et coûteux. En effet, chaque pièce métallique d'un lot doit d'abord être montée de manière très précise sur un support avant de les retoucher par usinage mécanique pour des étapes de terminaison. Comme les pièces de micromécanique sont très petites, le temps nécessaire pour monter individuellement toutes les petites pièces sur un support d'usinage est considérable.

Dans le but d'apporter une solution à ce problème, le document de brevet EP 2 767 870 enseigne d'associer, dans un même procédé de fabrication, la mise en œuvre d'une technologie de type LIGA et une étape d'usinage mécanique. Le procédé de fabrication d'une pièce de micromécanique décrit dans ce document antérieur comporte les étapes suivantes :
- se munir d'un substrat comportant une face supérieure électriquement conductrice ;
- déposer une couche de résine photosensible sur le substrat et la structurer afin de fabriquer un moule comportant des cavités dont le fond est formé par la face supérieure du substrat ;
- remplir de métal les cavités du moule par dépôt galvanique de manière à former une pièce métallique ;
- faire subir à la pièce métallique contenue dans le moule un usinage mécanique ;
- éliminer la résine photosensible formant le moule, puis libérer la pièce métallique du substrat.

Le procédé qui vient d'être cité présente l'avantage d'autoriser un usinage mécanique in situ de la pièce métallique avant que cette dernière ne soit séparée du moule dans lequel elle a été formée. On comprendra que cette manière de procéder permet d'exécuter l'usinage mécanique sur la base des mêmes cotes dont on dispose suite à la mise en œuvre de la technologie LIGA. Il en résulte un gain de temps et une économie d'argent considérable.

On comprendra que le procédé antérieur susmentionné permet d'effectuer a priori n'importe quelle opération d'usinage sur la surface supérieure de la structure formée par le moule et les pièces métalliques qu'il contient, avant de libérer la structure du substrat et d'éliminer la résine. En particulier, il est possible de former sur la partie supérieure de la pièce mécanique un niveau fonctionnel additionnel en usinant sélectivement une partie de celle-ci. Ce procédé connu présente toutefois certains défauts. En particulier, il a l'inconvénient de permettre uniquement l'usinage in situ de la partie supérieure de la pièce métallique contenue dans le moule. En effet, l'autre face de la structure formée par le moule et la pièce métallique est collée sur le substrat et donc inaccessible.

### BREF EXPOSE DE L'INVENTION

Un but de la présente invention est de remédier aux inconvénients de l'art antérieur qui viennent d'être expliqués. La présente invention atteint ce but ainsi que d'autres en fournissant un procédé de fabrication d'un lot de pièces métalliques conforme à la revendication 1 annexée.

Le procédé de l'invention a la particularité de comprendre au moins deux étapes d'usinage mécanique distinctes. L'une de ces étapes consiste en l'usinage de la partie supérieure de la structure formée par le moule et les pièces métalliques, alors que l'autre étape consiste en l'usinage de sa partie inférieure.

Conformément à un premier mode de mise en œuvre du procédé de l'invention, la première étape d'usinage mécanique, qui comporte la mise à niveau de la surface supérieure de la structure, est intercalée entre l'étape c) et l'étape d). On comprendra que conformément à ce premier mode de mise en œuvre, c'est le même substrat, sur lequel la structure a d'abord été formée, qui sert encore de support durant la première étape d'usinage mécanique. Ce mode de mise en œuvre présente l'avantage de réduire le nombre de manipulations. Toutefois, il nécessite d'utiliser un substrat suffisamment solide. En effet, beaucoup de substrats couramment utilisés dans le cadre de la technologie LIGA sont trop fragiles pour résister aux efforts mécaniques engendrés par l'usinage.

Conformément à une première variante du premier mode de mise en œuvre, la première étape d'usinage mécanique est mise à profit également pour usiner sélectivement les mêmes parties des portions supérieures de chacune des pièces métalliques du lot de pièces métalliques intégrées dans le moule. On comprendra toutefois que l'invention ne se limite pas à cette première variante. En effet, conformément notamment à une deuxième variante de ce même mode de mise en œuvre, on accomplit un usinage sélectif des mêmes parties des portions supérieures de chacune des pièces métalliques intégrées dans le moule durant une troisième étape d'usinage mécanique qui est intercalée, soit entre l'étape f) et l'étape g), soit entre l'étape d) et l'étape e). Autrement dit, selon cette deuxième variante, la mise à niveau de la surface supérieure, d'une part, et le façonnage des extrémités supérieures des pièces métalliques, d'autre part, sont réalisés durant deux étapes différentes du procédé. On comprendra que, selon cette deuxième variante du premier mode de mise en œuvre, il est nécessaire, d'une part, de fixer d'abord la structure sur un support avant d'exécuter la troisième étape d'usinage mécanique, et que d'autre part, la structure devra également être ensuite libérée du support.

Conformément à encore un autre mode particulier de mise en œuvre du procédé de l'invention, la première étape d'usinage mécanique, qui comporte la mise à niveau de la surface supérieure de la structure, est intercalée entre l'étape d) et l'étape e). On comprendra que dans ce cas, il est nécessaire d'une part de fixer d'abord la structure sur un support avant de l'usiner mécaniquement, et qu'il est nécessaire également d'autre part de détacher ensuite la structure du support pour pouvoir la retourner en vue de l'étape e). On comprendra que, selon ce mode particulier de mise en œuvre, le support sur lequel on fixe la structure pour la première étape d'usinage mécanique n'est pas la même pièce que le substrat sur lequel la structure a été formée. Le substrat n'a donc pas besoin d'être particulièrement solide.

### BREVE DESCRIPTION DES FIGURES

D'autres caractéristiques et avantages de la présente invention apparaîtront à la lecture de la description qui va suivre, donnée uniquement à titre d'exemple non limitatif, et faite en référence aux dessins annexés dans lesquels :

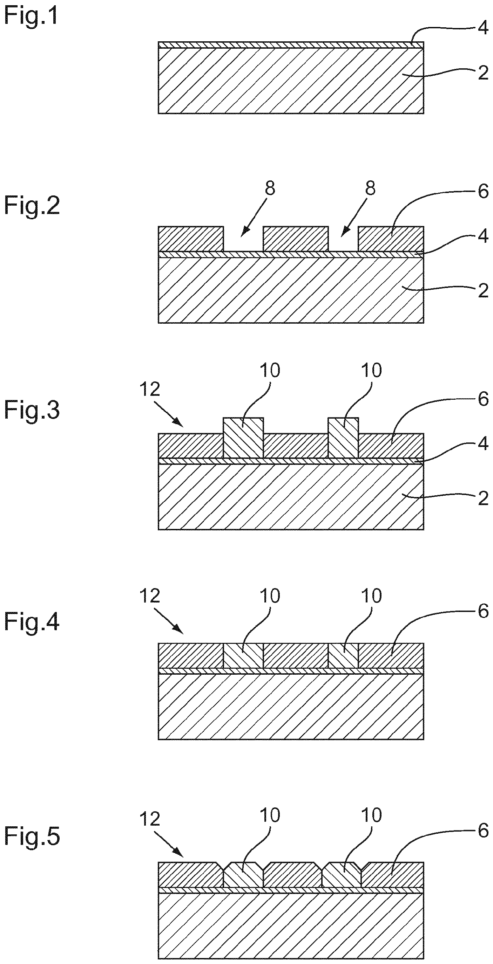

- les figures 1 à 13 sont des vues schématiques en coupe qui illustrent respectivement différentes étapes du procédé de l'invention conformément à divers modes de mise en œuvre.

### DESCRIPTION DETAILLEE DE MODES DE MISE EN ŒUVRE

On va maintenant décrire le déroulement d'une première variante de mise en œuvre du procédé de l'invention en faisant référence aux figures 1 à 8 et au tableau I annexés. La première étape mentionnée dans le tableau I (étape « a ») consiste à se munir d'un substrat comportant une face supérieure électriquement conductrice (figure 1). Dans le présent exemple, le substrat 2 est constitué par une plaquette de silicium dont l'épaisseur est au moins égale à 0.3 mm. (et de préférence au moins égale à 1 mm.) et sur la surface supérieure de laquelle une couche conductrice 4 a été formée par dépôt en phase vapeur. Selon une autre variante (non représentée), la couche électriquement conductrice pourrait être obtenue en dopant superficiellement le silicium qui constitue la face supérieure de la plaquette 2 de manière à le rendre conducteur. Quelle que soit la manière dont elle a été formée, la couche électriquement conductrice 4 est destinée à servir de couche d'amorçage, c'est-à-dire de cathode, lors d'un dépôt galvanique ultérieur. On comprendra que la couche conductrice servira également d'interface entre le substrat 2 et les pièces métalliques 10 qui seront formées grâce à la technologie LIGA. Conformément au mode de mise en œuvre qui fait l'objet du présent exemple, comme on le verra plus en détail plus loin, il est important que la couche conductrice 4 puisse assurer une forte adhérence des pièces métalliques 10 sur le substrat 2. A cet égard, on précisera encore que, si la couche d'amorçage 4 n'est pas obtenue par dopage, elle est typiquement formée d'une sous-couche de chrome ou de titane recouverte d'une couche d'or ou de cuivre.

L'invention ne se limite pas à des procédés utilisant un substrat en silicium. Ce dernier pourrait alternativement être constitué d'une plaque de verre ou de céramique, ou même d'une plaque en métal, en acier inoxydable par exemple. On comprendra que dans ce dernier cas, il n'est pas indispensable de déposer une couche conductrice. Toutefois, la surface de la plaque en inox devra en général être dégraissée, voire traitée chimiquement ou physiquement avant usage.

Selon le tableau I, l'étape suivante (l'étape « b », figure 2) consiste à déposer une couche de résine photosensible 6 sur le substrat 2 et à la structurer afin de fabriquer un moule comportant des cavités 8 dont le fond est constitué par la face supérieure 4 du substrat 2. Conformément au présent exemple, cette étape comprend une première sous-étape consistant à recouvrir la surface conductrice 4 du substrat 2 d'une couche de résine photosensible 6. La résine utilisée est de préférence un photorésist négatif qui est conçu pour polymériser sous l'action d'un rayonnement UV. A titre d'exemple, on peut utiliser comme photorésist négatif le SU-8 commercialisé par Shell Chemical. Alternativement, la résine photosensible pourrait être un photorésist positif conçu pour se décomposer sous l'action d'un rayonnement UV. On comprendra que la présente invention ne se limite pas à quelques types particuliers de résines photosensibles. L'homme du métier saura choisir une résine photosensible convenant à ses besoins parmi toutes les résines connues qui sont adaptées à la photolithographie par UV.

La résine 6 peut être déposée sur la couche d'amorçage 4 à l'aide de toute technique connue de l'homme du métier, par exemple, à la tournette (spin coating), ou par laminage lorsqu'il s'agit d'une résine « solide », etc. L'épaisseur de la couche de résine photosensible 6 est typiquement comprise entre 20 et 500 µm. Selon l'épaisseur et la technique utilisée, la résine pourra être déposée en une ou plusieurs fois.

Selon une variante particulière du procédé de l'invention, une fois la couche de résine 6 déposée, elle subit encore un précuit au cours duquel elle est chauffée et maintenue entre 50 et 150 °C pendant une durée suffisante pour évaporer les solvants (pre-bake). L'homme du métier comprendra toutefois que selon la nature de la résine utilisée, cette étape de précuit n'est pas forcément nécessaire.

La deuxième sous-étape de l'étape « b » consiste à irradier la couche de résine 6 au moyen d'un rayonnement UV à travers les ouvertures d'un masque (non représenté) définissant le contour des cavités 8 que doit comporter le moule. L'ampleur de l'irradiation dépend de l'épaisseur de la résine 6. Elle est typiquement comprise entre 50 et 1000mJ/cm2. Le cas échéant, un recuit de la couche (post-bake) peut être nécessaire pour compléter la polymérisation induite par l'irradiation UV. Avec une résine comme le SU-8 utilisé dans le présent exemple, l'étape de recuit est de préférence effectuée entre 50 et 150°C durant 15 minutes à 3 heures. Les zones insolées (photopolymérisées) deviennent ainsi insensibles à une grande majorité des liquides de développement. Par contre, les zones non insolées pourront ultérieurement être dissoutes en utilisant un liquide de développement adéquat.

L'étape « b » comprend ensuite encore une autre sous-étape consistant à développer la couche de résine photosensible 6 (figure 2). Pour le développement du photorésist négatif du présent exemple, on utilise de préférence un solvant du type PGMEA qui a pour effet de dissoudre les zones non insolées et de faire apparaître par endroit la couche conductrice 4 du substrat 2. Ensuite, selon une variante avantageuse, on parachève l'étape de développement par une brève exposition à un plasma de manière à bien nettoyer le moule en résine et à en activer la surface en prévision de l'étape suivante.

En se référant toujours au tableau I, l'étape suivante (étape « c », figure 3) consiste à remplir de métal les cavités 8 du moule par dépôt galvanique de manière à former un lot de pièces métalliques identiques 10 intégrées dans le moule, le moule et les pièces métalliques formant une structure 12 comportant une surface inférieure collée à la face supérieure 4 du substrat 2 et une surface supérieure. On comprendra de ce qui précède que les parois des cavités 8 sont sensiblement verticales. Les pièces métalliques réalisées par galvanoplastie ont donc des formes de prismes droits implantés verticalement. Grâce à l'utilisation de la photolithographie, les pièces métalliques 10 peuvent avoir des cotes extrêmement précises, propres à respecter les tolérances très élevées d'une pièce de micromécanique dans le domaine de l'horlogerie par exemple.

L'étape suivante (l'étape « x ») constitue la première étape d'usinage mécanique du procédé. Conformément à l'exemple qui fait l'objet du tableau I, cette étape consiste dans l'usinage mécanique de la surface supérieure de la structure 12 formée du moule et des pièces métalliques 10. L'étape « x » comprend d'une part la mise à niveau de la surface supérieure de la structure 12 par abrasion et polissage (figure 4), et d'autre part l'usinage sélectif de certaines parties des pièces métalliques 10 de manière à en structurer les parties supérieures (figure 5). On comprendra qu'un tel façonnage permet de changer la forme des pièces métalliques de manière à transformer leur structure prismatique en une nouvelle structure plus complexe. En particulier, le procédé de l'invention permet de réaliser par usinage mécanique des pièces de micromécanique multi-niveaux à partir de pièces métalliques formées au départ par croissance galvanique sur un seul niveau. On peut donc obtenir la pièce souhaitée sans qu'il soit nécessaire d'avoir recours à un moule formé d'un empilement de couches distinctes de résine photosensible.

On comprendra que les pièces métalliques 10 peuvent être soumises à de fortes contraintes durant la première étape d'usinage mécanique. En particulier, si les pièces métalliques n'adhèrent pas de façon suffisamment forte au substrat 2, les contraintes de cisaillement engendrées par l'usinage mécanique au niveau de la jonction 4 entre les pièces métalliques 10 et le substrat 2 peuvent être suffisamment intenses pour délaminer au moins partiellement les pièces métalliques. Même si, la présence du moule en résine 6 entourant les pièces métalliques 10 évite que ces dernières ne se détachent complètement, le positionnement extrêmement précis inhérent à la fabrication des pièces métalliques par lots selon la technologie LIGA risque d'être totalement dégradé par l'usinage mécanique. On comprend donc toute l'importance de veiller à ce que la couche conductrice 4 assure une forte adhérence des pièces métalliques 10 sur le substrat 2.

L'étape suivante du tableau I (étape « d ») consiste à libérer la structure 12 du substrat 2. Rappelons que conformément au présent exemple, le substrat 2 est constitué par une plaquette de silicium sur laquelle les pièces métalliques 10 adhèrent fortement. Dans ces conditions, il serait délicat d'essayer de délaminer sans la briser la structure 12 constituée des pièces métalliques 10 et du moule 6. L'étape « d » de libération de la structure est donc effectuée de préférence par dissolution sélective de la plaque de silicium 2 dans un bain de potasse (KOH) ou par sous-gravure de la couche conductrice. Une fois libérée du substrat 2, la structure 12 présente la forme d'une feuille de résine et de métal dont l'épaisseur est typiquement de quelques centaines de microns. L'expérience montre que les forces internes exercées entre les pièces métalliques 10 et leur moule en résine 6 donnent suffisamment de stabilité à l'ensemble pour maintenir la cohésion de la structure 12.

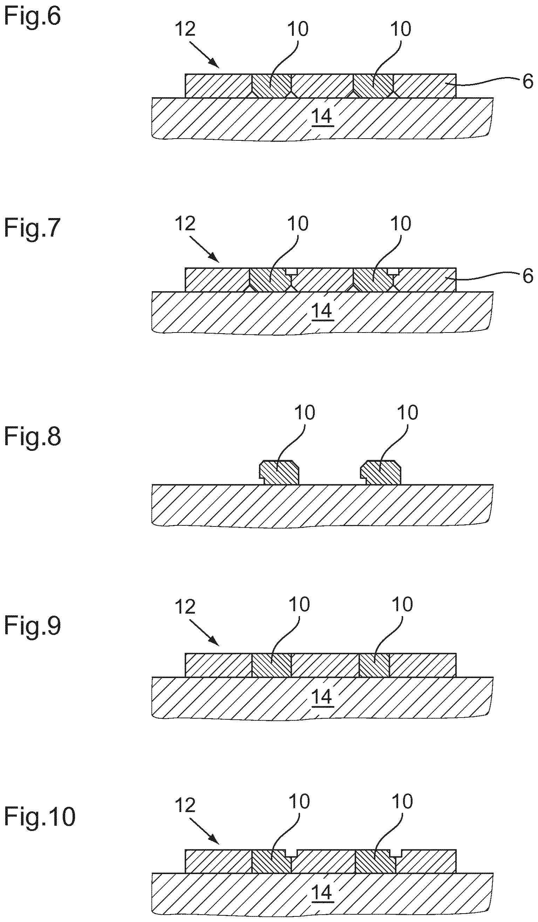

L'étape suivante du tableau I (étape « e » ; figure 6) consiste à fixer la structure 12 sur un support 14 en position retournée, de sorte que la surface supérieure de la structure 12 soit plaquée contre le support 14 et que la surface inférieure soit maintenant exposée. Dans cette configuration, les positions relatives des pièces métalliques 10 sont conservées ce qui facilite le suivi et le contrôle de chaque pièce tout au long de la chaîne de fabrication. Conformément au présent mode de mise en œuvre, le support 14 est constitué par une pièce métallique massive sur laquelle la structure 12 est fixée à l'aide d'une colle, d'une résine ou d'une cire. On comprendra toutefois que l'invention ne se limite pas à quelques modes de fixation particuliers. En particulier, selon un autre mode de mise en œuvre non illustré, la pièce métallique massive constituant le support 14 pourrait présenter en surface des canaux reliés à un système d'aspiration. On comprendra qu'avec un tel support à vide, la structure 12 n'aurait pas besoin d'être colée puisque l'aspiration suffirait pour la maintenir plaquée contre le support 14. Selon encore une autre variante, des supports poreux à vides, par exemple sous la forme de pierres poreuses, pourraient être substituées aux canaux d'aspiration formés dans la surface en métal. Un tel agencement garantirait une aspiration encore plus uniforme sur toute la surface du support 14.

L'étape suivante du tableau I (étape « f » ; figure 7) consiste en une deuxième étape d'usinage mécanique durant laquelle on usine la surface inférieure de la structure 12. La surface inférieure n'a en principe pas besoin d'être mise à niveau puisqu'elle a hérité du caractère plan de la face supérieure du substrat 2 sur lequel la structure 12 a été formée. Toutefois, comme dans le présent exemple on a libéré la structure 12 du substrat 2 par dissolution de ce dernier, il peut subsister sur la surface inférieure quelques reliquats de la couche d'amorçage 4 qu'il est possible d'éliminer par exemple par abrasion et polissage. La deuxième étape d'usinage mécanique comprend en outre de préférence l'action d'usiner sélectivement certaines parties des pièces métalliques 10 de manière à en structurer la partie inférieure (figure 7). On comprendra que cette opération permet de changer la forme de la partie inférieure des pièces métalliques 10 de manière à changer la forme de prisme droit en une nouvelle structure plus complexe. On comprendra notamment que grâce à la présence dans le procédé de l'invention de deux étapes d'usinage mécanique distinctes, il est possible de réaliser des lots de pièces métalliques avec trois niveaux distincts ou même plus, sans qu'il soit nécessaire d'avoir recours à un moule formé d'un empilement de plusieurs couches de résine photosensible.

La dernière étape mentionnée dans le tableau I (étape « g » ; figure 8) consiste à libérer les pièces métalliques 10 du support 14 et de la structure 12. Conformément au présent exemple, on libère les pièces métalliques de la structure par voie chimique ou par décapage au plasma. On comprendra toutefois que le « stripping » peut être réalisé de plusieurs autres manières.

On va maintenant décrire le déroulement d'une deuxième variante de mise en œuvre du procédé de l'invention en faisant référence successivement aux figures 1 à 4, 9 à 11, et 8, ainsi qu'au tableau II annexé. Si on compare le tableau II au tableau I, on peut observer que les huit étapes désignées respectivement par les lettres allant de « a » à « g », ainsi que l'étape « x », sont présentes dans les deux tableaux, mais que le tableau II comporte encore deux étapes supplémentaires qui ne figurent pas dans le tableau I. Ces deux étapes supplémentaires sont désignées par les appellations « pré y » et « y », et elles s'insèrent ensemble entre l'étape « f » et l'étape « g ».

Le tableau II et le tableau I commence par les quatre mêmes étapes « a », « b », « c » et « x ». C'est donc lors de l'étape « x », la première étape d'usinage mécanique, que la deuxième variante de mise en œuvre diverge de la première. En effet, selon le tableau II, la première étape d'usinage ne comprend pas le façonnage de la surface supérieure de la structure 12, mais se limite uniquement à la mise à niveau de cette surface (figure 4). Une fois la mise à niveau effectuée, le procédé passe directement à l'étape « d » lors de laquelle la structure 12 est libérée du substrat 2. Dans le tableau II, comme dans le tableau I, l'étape « d » est suivie par les étapes « e » et « f ». On comprendra que ces étapes peuvent par exemple être mises en œuvre ici de la même manière que dans le précédent exemple basé sur le tableau I.

Conformément à la variante de mise en œuvre qui fait l'objet du présent exemple, le façonnage de la surface supérieure de la structure 12 est effectué au cours d'une troisième étape d'usinage mécanique (étape « y ») qui se déroule après la deuxième étape d'usinage mécanique (étape « f »). Dans ces conditions, on comprendra en particulier qu'il est nécessaire de retourner la structure 12 entre la fin de la deuxième étape d'usinage mécanique (étape « f ») et le début de la troisième étape d'usinage mécanique (étape « y »). A cet effet, le tableau II comporte une étape « pré y » consistant en la libération de la structure 12 du support 14, en la remise de cette structure à l'endroit, et enfin en sa refixation sur le même support 14 (ou alternativement sur un autre support). Au terme de l'étape « pré y » la structure ayant été retournée une nouvelle fois, c'est à nouveau sa surface supérieure qui est exposée.

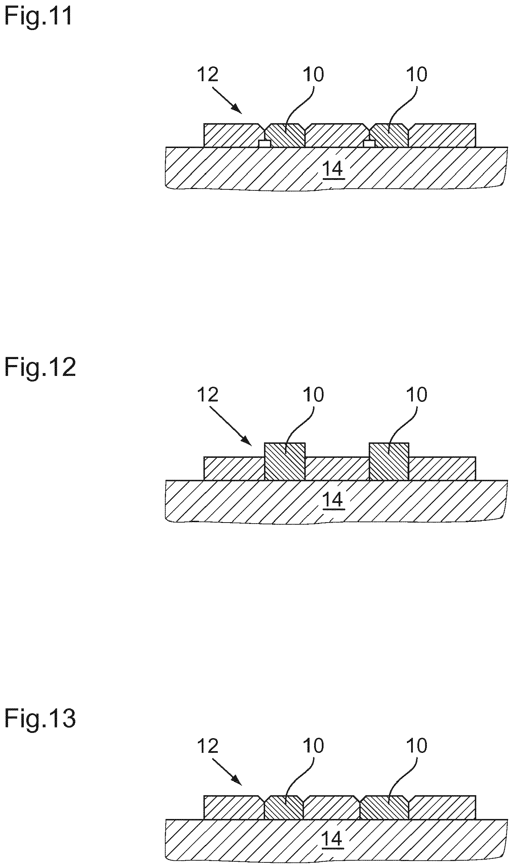

Dans le tableau II, l'étape « pré y » est suivie de l'étape « y » qui, comme on l'a déjà dit, consiste à façonner la surface supérieure de la structure 12 en usinant sélectivement certaines parties des pièces métalliques 10 de manière à en structurer les parties supérieures (figure 11). Comme déjà noté en rapport avec la première variante de mise en œuvre du procédé de l'invention, l'étape « f » et l'étape « y » de la deuxième variante permettent chacune de changer la forme d'une des extrémités des pièces métalliques de manière à transformer leur structure prismatique en une nouvelle structure plus complexe.

On va maintenant décrire le déroulement d'une troisième variante de mise en œuvre du procédé de l'invention en faisant référence successivement aux figures 1 à 3, 12, 13 et 6 à 8, ainsi qu'au tableau III annexé. Si on compare le tableau III au tableau I, on peut observer que les huit étapes désignées respectivement par les lettres allant de « a » à « g », ainsi que l'étape « x », sont présentes dans les deux tableaux, mais que l'étape « x » est intercalée entre les étapes « d » et « e » au lieu d'être intercalée entre les étapes « c » et « d » comme dans le tableau I. De plus, le tableau III comporte encore deux étapes supplémentaires qui ne figurent pas dans le tableau I. Ces deux étapes supplémentaires sont désignées par les appellations « pré x » et « post x », et elles s'insèrent respectivement immédiatement avant et après l'étape « x ».

Le tableau III et le tableau I commence par les mêmes étapes « a », « b » et « c ». C'est donc essentiellement le moment particulier auquel on effectue la première étape d'usinage mécanique qui distingue la troisième variante de mise en œuvre de la première. En effet, selon le tableau III, suite à l'étape « c », on libère la structure 12 du substrat (étape « d ») et on la fixe sur un support 14 (étape « pré x », figure 12) avant d'effectuer la première étape d'usinage mécanique de la surface supérieure de la structure 12 formée du moule et des pièces métalliques (étape « x »). L'étape « x » comprend d'une part la mise à niveau de la surface supérieure de la structure 12 par abrasion et polissage, et d'autre part l'usinage sélectif de certaines parties des pièces métalliques 10 de manière à en structurer les parties supérieures (figure 13).

Selon le tableau III, une fois la première étape d'usinage mécanique accomplie, l'étape suivante (étape « post x ») consiste à détacher la structure 12 du support 14, de manière à pouvoir ensuite la retourner et la fixer dans l'autre sens sur le support lors de l'étape « e ». Les étapes « e », « f » et « g » peuvent ensuite être mise en œuvre par exemple de la même manière qu'avec la première variante du procédé.

On comprendra en outre que diverses modifications et/ou améliorations évidentes pour un homme du métier peuvent être apportées aux modes de mise en œuvre qui font l'objet de la présente description sans sortir du cadre de la présente invention définie par les revendications annexées.

**Tableau I**

| | |
|---|---|
| Etape « a » | se munir d'un substrat comportant une face supérieure électriquement conductrice (figure 1) |
| Etape « b » | structurer une couche de résine photosensible déposée sur le substrat, afin de fabriquer un moule comportant des cavités dont la face supérieure du substrat constitue le fond (figure 2) |
| Etape « c » | remplir de métal les cavités du moule par dépôt galvanique de manière à former un lot de pièces métalliques identiques intégrées dans le moule, le moule et les pièces métalliques formant une structure comportant une surface inférieure collée à la face supérieure du substrat et une surface supérieure (figure 3) |
| Etape « x » | Durant une première étape d'usinage mécanique, mettre à niveau la surface supérieure de la structure (figure 4), et façonner cette surface par usinage sélectif des mêmes parties de chacune des pièces métalliques (figure 5) |
| Etape « d » | libérer la structure du substrat |
| Etape « e » | fixer la structure sur un support en position retournée, de manière que ce soit la surface supérieure de la structure qui se trouve en regard du support et la surface inférieure qui est exposée (figure 6) |
| Etape « f » | Exécuter une deuxième étape d'usinage mécanique consistant à façonner la surface inférieure de la structure par un usinage sélectif des mêmes parties de chacune des pièces métalliques (figure 7) |
| Etape « g » | libérer les pièces métalliques du support et du moule (figure 8) |

**Tableau II**

| | |
|---|---|
| Etape « a » | se munir d'un substrat comportant une face supérieure électriquement conductrice (figure 1) |
| Etape « b » | structurer une couche de résine photosensible déposée sur le substrat, afin de fabriquer un moule comportant des cavités dont la face supérieure du substrat constitue le fond (figure 2) |
| Etape « c » | remplir de métal les cavités du moule par dépôt galvanique de manière à former un lot de pièces métalliques identiques intégrées dans le moule, le moule et les pièces métalliques formant une structure comportant une surface inférieure collée à la face supérieure du substrat et une surface supérieure (figure 3) |
| Etape « x » | Mettre à niveau la surface supérieure de la structure durant une première étape d'usinage mécanique (figure 4) |
| Etape « d » | libérer la structure du substrat |
| Etape « e » | fixer la structure sur un support en position retournée, de manière que ce soit la surface supérieure de la structure qui se trouve en regard du support et la surface inférieure qui est exposée (figure 9) |
| Etape « f » | Exécuter une deuxième étape d'usinage mécanique consistant à façonner la surface inférieure de la structure par un usinage sélectif des mêmes parties de chacune des pièces métalliques identiques (figure 10) |
| Etape « pré y » | libérer la structure du support, puis la fixer à nouveau sur le support tournée dans l'autre sens, de façon que ce soit la surface supérieure qui est exposée. |
| Etape « y » | Exécuter une troisième étape d'usinage mécanique consistant à façonner la surface supérieure de la structure par un usinage sélectif des mêmes parties de chacune des pièces métalliques identiques (figure 11) |
| Etape « g » | libérer les pièces métalliques du support et du moule (figure 8) |

**Tableau III**

| | |
|---|---|
| Etape « a » | se munir d'un substrat comportant une face supérieure électriquement conductrice (figure 1) |
| Etape « b » | structurer une couche de résine photosensible déposée sur le substrat, afin de fabriquer un moule comportant des cavités dont la face supérieure du substrat constitue le fond (figure 2) |
| Etape « c » | remplir de métal les cavités du moule par dépôt galvanique de manière à former un lot de pièces métalliques identiques intégrées dans le moule, le moule et les pièces métalliques formant une structure avec une surface inférieure collée à la face supérieure du substrat et une surface supérieure (figure 3) |
| Etape « d » | libérer la structure du substrat |
| Etape « pré x » | fixer la structure sur un support de manière que la surface inférieure soit en regard du support et que la surface supérieure soit exposée (figure 12) |
| Etape « x » | Durant une première étape d'usinage mécanique, mettre à niveau la surface supérieure de la structure, et façonner cette dernière par le moyen d'un usinage sélectif des mêmes parties de chacune des pièces métalliques identiques (figure 13) |
| Etape « post x » | détacher la structure du support |
| Etape « e » | fixer la structure sur un support en position retournée, de manière que ce soit la surface supérieure de la structure qui se trouve en regard du support et la surface inférieure qui est exposée (figure 6) |
| Etape « f » | Exécuter une deuxième étape d'usinage mécanique consistant à façonner la surface inférieure de la structure par un usinage sélectif des mêmes parties de chacune des pièces métalliques (figure 7) |
| Etape « g » | libérer les pièces métalliques du support et du moule (figure 8). |

## Revendications

1. Procédé de fabrication d'un lot de pièces métalliques, **caractérisé en ce qu'**il comporte les étapes suivantes :
a. se munir d'un substrat (2) comportant une face supérieure (4) électriquement conductrice ;
b. structurer une couche de résine photosensible (6) déposée sur le substrat (2), afin de fabriquer un moule comportant des cavités (8) dont la face supérieure (4) du substrat (2) constitue le fond ;
c. remplir de métal les cavités (8) du moule par dépôt galvanique de manière à former un lot de pièces métalliques (10) intégrées dans le moule, le moule et les pièces métalliques formant une structure (12) comportant une surface inférieure collée à la face supérieure (4) du substrat (2) et une surface supérieure ;
d. libérer la structure (12) du substrat (2) ;
e. la surface supérieure de la structure (12) ayant préalablement été mise à niveau durant une première étape d'usinage mécanique, fixer la structure (12) sur un support (14) en position retournée, de manière que ce soit la surface supérieure de la structure (12) qui se trouve en regard du support (14) et la surface inférieure qui est exposée ;
f. façonner la surface inférieure de la structure (12) durant une deuxième étape d'usinage mécanique, avant de libérer la structure (12) du support (14) ;
g. libérer les pièces métalliques (10) du moule.

2. Procédé de fabrication d'un lot de pièces métalliques conforme à la revendication 1, **caractérisé en ce que** la première étape d'usinage mécanique comportant la mise à niveau de la surface supérieure de la structure (12), est mise en œuvre entre l'étape c) et l'étape d).

3. Procédé de fabrication d'un lot de pièces métalliques conforme à la revendication 2, **caractérisé en ce que** ladite première étape d'usinage mécanique consiste non seulement à mettre à niveau la surface supérieure de la structure (12), mais consiste également à façonner la surface supérieure de la structure par un usinage sélectif des mêmes parties de chacune des pièces métalliques (10) du lot de pièces métalliques intégrées dans le moule.

4. Procédé de fabrication d'un lot de pièces métalliques conforme à la revendication 2, **caractérisé en ce qu'**il comporte, entre l'étape f) et l'étape g) ou entre l'étape d) et l'étape e), une troisième étape d'usinage mécanique consistant à façonner la surface supérieure de la structure (12) par un usinage sélectif des mêmes parties de chacune des pièces métalliques (10) du lot de pièces métalliques intégrées dans le moule, et **en ce que** le procédé comporte encore, avant la troisième étape d'usinage mécanique, une sous-étape de fixation consistant à fixer la structure (12) sur un support (14) de manière que la surface inférieure soit en regard du support et que la surface supérieure soit exposée, et comporte en outre après la troisième étape d'usinage mécanique, une sous-étape de libération consistant à détacher la structure (12) du support (14).

5. Procédé de fabrication d'un lot de pièces métalliques conforme à la revendication 1, **caractérisé en ce que** la première étape d'usinage mécanique comportant la mise à niveau de la surface supérieure de la structure (12), est mise en œuvre entre l'étape d) et l'étape e), et **en ce que** le procédé comporte encore, avant la première étape d'usinage mécanique, une sous-étape de fixation consistant à fixer la structure (12) sur un support (14) de manière que la surface inférieure soit en regard du support (14) et que la surface supérieure soit exposée, et comporte en outre après la première étape d'usinage mécanique, une sous-étape de libération consistant à détacher la structure (12) du support (14).

6. Procédé de fabrication d'un lot de pièces métalliques conforme à la revendication 5, **caractérisé en ce que** ladite première étape d'usinage mécanique consiste non seulement à mettre à niveau la surface supérieure de la structure (12), mais consiste également à façonner la surface supérieure de la structure par un usinage sélectif des mêmes parties de chacune des pièces métalliques (10) du lot de pièces métalliques intégrées dans le moule.

7. Procédé de fabrication d'un lot de pièces métalliques conforme à l'une quelconque des revendications précédentes, **caractérisé en ce que** le substrat (2) comporte une plaquette de silicium.

8. Procédé de fabrication d'un lot de pièces métalliques conforme à la revendication 7, **caractérisé en ce que** le silicium constituant la face supérieure de la plaquette est dopé de sorte à le rendre électriquement conducteur.

9. Procédé de fabrication d'un lot de pièces métalliques conforme à la revendication 7, **caractérisé en ce que** le substrat (2) est constitué d'une plaquette de silicium et d'une couche en matériau électriquement conducteur déposée sur la face supérieure (4) de la plaquette.

10. Procédé de fabrication d'un lot de pièces métalliques conforme à l'une quelconque des revendications précédentes, **caractérisé en ce que** la deuxième étape d'usinage mécanique consistant à façonner la surface inférieure de la structure (12) (étape f) comprend l'usinage sélectif des mêmes parties de chacune des pièces (10) du lot de pièces métalliques intégrées dans le moule.

## Patentansprüche

1. Verfahren zur Herstellung eines Satzes von Metallteilen, **dadurch gekennzeichnet, dass** es die folgenden Schritte umfasst:
a. Vorsehen eines Substrats (2), das eine elektrisch leitfähige obere Seite (4) umfasst;
b. Strukturieren einer Schicht aus lichtempfindlichem Harz (6), das auf dem Substrat (2) aufgebracht ist, um eine Form herzustellen, die Hohlräume (8) umfasst, bei denen die obere Seite (4) des Substrats (2) den Boden bildet;
c. Füllen der Hohlräume (8) der Form mit Metall durch galvanische Abscheidung, derart, dass ein Satz von Metallteilen (10) gebildet wird, die in der Form integriert sind, wobei die Form und die Metallteile eine Struktur (12) bilden, die eine untere Fläche, die an die obere Seite (4) des Substrats (2) geklebt ist, und eine obere Fläche umfasst;
d. Befreien der Struktur (12) von dem Substrat (2);
e. nachdem die obere Fläche der Struktur (12) im Voraus während eines ersten mechanischen Bearbeitungsschritts nivelliert wurde, Befestigen der Struktur (12) an einem Träger (14) in der umgedrehten Position, derart dass die obere Fläche der Struktur (12) sich dem Träger (14) gegenüberliegend befindet und die untere Fläche freiliegt;
f. Formen der unteren Fläche der Struktur (12) während eines zweiten mechanischen Bearbeitungsschritts vor dem Befreien der Struktur (12) von dem Träger (14);
g. Befreien der Metallteile (10) aus der Form.

2. Verfahren zur Herstellung eines Satzes von Metallteilen nach Anspruch 1, **dadurch gekennzeichnet, dass** der erste mechanische Bearbeitungsschritt, der das Nivellieren der oberen Fläche der Struktur (12) umfasst, zwischen dem Schritt c) und dem Schritt d) durchgeführt wird.

3. Verfahren zur Herstellung eines Satzes von Metallteilen nach Anspruch 2, **dadurch gekennzeichnet, dass** der erste mechanische Bearbeitungsschritt nicht nur in dem Nivellieren der oberen Fläche der Struktur (12) besteht, sondern auch im Formen der oberen Fläche der Struktur durch eine selektive Bearbeitung der gleichen Abschnitte von jedem der Metallteile (10) des Satzes von Metallteilen, die in die Form integriert sind, besteht.

4. Verfahren zur Herstellung eines Satzes von Metallteilen nach Anspruch 2, **dadurch gekennzeichnet, dass** es zwischen dem Schritt f) und dem Schritt g) oder zwischen dem Schritt d) und dem Schritt e) einen dritten mechanischen Bearbeitungsschritt umfasst, der darin besteht, die obere Fläche der Struktur (12) durch eine selektive Bearbeitung der gleichen Abschnitte von jedem von den Metallteilen (10) des Satzes von Metallteilen, die in der Form integriert sind, zu formen, und dadurch, dass das Verfahren vor dem dritten mechanischen Bearbeitungsschritt noch einen Unterschritt zur Befestigung umfasst, der darin besteht, die Struktur (12) derart an einem Träger (14) zu befestigen, dass die untere Fläche dem Träger gegenüberliegend ist und dass die obere Fläche freiliegt, und ferner nach dem dritten mechanischen Bearbeitungsschritt einen Unterschritt des Befreiens umfasst, der darin besteht, die Struktur (12) von dem Träger (14) abzutrennen.

5. Verfahren zur Herstellung eines Satzes von Metallteilen nach Anspruch 1, **dadurch gekennzeichnet, dass** der erste mechanische Bearbeitungsschritt, der das Nivellieren der oberen Fläche der Struktur (12) umfasst, zwischen dem Schritt d) und dem Schritt e) durchgeführt wird, und dadurch, dass das Verfahren ferner vor dem ersten mechanischen Bearbeitungsschritt einen Unterschritt zur Befestigung umfasst, der darin besteht, die Struktur (12) derart an einem Träger (14) zu befestigen, dass die untere Fläche sich dem Träger (14) gegenüberliegend befindet, und dass die obere Fläche freiliegt, und ferner nach dem ersten mechanischen Bearbeitungsschritt einen Unterschritt des Befreiens umfasst, der darin besteht, die Struktur (12) von dem Träger (14) abzutrennen.

6. Verfahren zur Herstellung eines Satzes von Metallteilen nach Anspruch 5, **dadurch gekennzeichnet, dass** der erste mechanische Bearbeitungsschritt nicht nur im Nivellieren der oberen Fläche der Struktur (12) besteht, sondern auch im Formen der oberen Fläche der Struktur durch eine selektive Bearbeitung der gleichen Abschnitte von jedem der Metallteile (10) des Satzes von Metallteilen, die in der Form integriert sind, besteht.

7. Verfahren zur Herstellung eines Satzes von Metallteilen nach einem der vorhergehenden Ansprüche, **dadurch gekennzeichnet, dass** das Substrat (2) eine Siliziumplatte umfasst.

8. Verfahren zur Herstellung eines Satzes von Metallteilen nach Anspruch 7, **dadurch gekennzeichnet, dass** das Silizium, das die obere Seite der Platte bildet, derart dotiert wird, dass es elektrisch leitfähig wird.

9. Verfahren zur Herstellung eines Satzes von Metallteilen nach Anspruch 7, **dadurch gekennzeichnet, dass** das Substrat (2) aus einer Siliziumplatte und einer Schicht aus elektrisch leitfähigem Material besteht, das auf der oberen Seite (4) der Platte aufgebracht ist.

10. Verfahren zur Herstellung eines Satzes von Metallteilen nach einem der vorhergehenden Ansprüche, **dadurch gekennzeichnet, dass** der zweite mechanische Bearbeitungsschritt, der darin besteht, die untere Fläche der Struktur (12) zu formen (Schritt f), die selektive Bearbeitung der gleichen Abschnitte von jedem der Teile (10) des Satzes von Metallteilen, die in der Form integriert sind, umfasst.

## Claims

1. Method for producing a batch of metal parts, **characterised in that** it comprises the following steps:
a. obtaining a substrate (2) having an electrically conductive upper face (4);
b. structuring a layer of photosensitive resin (6) deposited onto the substrate (2) so as to manufacture a mould having cavities (8), the upper face (4) of the substrate (2) forming the base thereof;
c. filling the cavities (8) of the mould with metal by electrodeposition so as to form a batch of metal parts (10) integrated in the mould, the mould and the metal parts forming a structure (12) comprising a lower surface adhered to the upper face (4) of the substrate (2), and an upper surface;
d. releasing the structure (12) from the substrate (2);
e. with the upper surface of the structure (12) having previously been made level during a first mechanical machining step, fixing the structure (12) upside-down on a support (14) such that it is the upper surface of the structure (12) which faces the support (14) and the lower surface which is exposed;
f. shaping the lower surface of the structure (12) during a second mechanical machining step before releasing the structure (12) from the support (14);
g. releasing the metal parts (10) from the mould.

2. Method for producing a batch of metal parts as claimed in claim 1, **characterised in that** the first mechanical machining step comprising making the upper surface of the structure (12) level is carried out between step c) and step d).

3. Method for producing a batch of metal parts as claimed in claim 2, **characterised in that** said first mechanical machining step consists not only of making the upper surface of the structure (12) level but likewise consists of shaping the upper surface of the structure by selectively machining the same portions of each of the metal parts (10) of the batch of metal parts integrated in the mould.

4. Method for producing a batch of metal parts as claimed in claim 2, **characterised in that** it comprises, between step f) and step g) or between step d) and step e), a third mechanical machining step consisting of shaping the upper surface of the structure (12) by selectively machining the same portions of each of the metal parts (10) of the batch of metal parts integrated in the mould, and **in that** the method further comprises, before the third mechanical machining step, a fixing sub-step consisting of fixing the structure (12) to a support (14) such that the lower surface faces the support and that the upper surface is exposed, and further comprises, after the third mechanical machining step, a releasing sub-step consisting of detaching the structure (12) from the support (14).

5. Method for producing a batch of metal parts as claimed in claim 1, **characterised in that** the first mechanical machining step comprising making the upper surface of the structure (12) level is carried out between step d) and step e), and **in that** the method further comprises, before the first mechanical machining step, a fixing sub-step consisting of fixing the structure (12) to a support (14) such that the lower surface faces the support (14) and that the upper surface is exposed, and further comprises, after the first mechanical machining step, a releasing sub-step consisting of detaching the structure (12) from the support (14).

6. Method for producing a batch of metal parts as claimed in claim 5, **characterised in that** said first mechanical machining step consists not only of making the upper surface of the structure (12) level but likewise consists of shaping the upper surface of the structure by selectively machining the same portions of each of the metal parts (10) of the batch of metal parts integrated in the mould.

7. Method for producing a batch of metal parts as claimed in any one of the preceding claims, **characterised in that** the substrate (2) comprises a silicon wafer.

8. Method for producing a batch of metal parts as claimed in claim 7, **characterised in that** the silicon forming the upper face of the wafer is doped so as to make it electrically conductive.

9. Method for producing a batch of metal parts as claimed in claim 7, **characterised in that** the substrate (2) is formed of a silicon wafer and a layer of electrically conductive material deposited on the upper face (4) of the wafer.

10. Method for producing a batch of metal parts as claimed in any one of the preceding claims, **characterised in that** the second mechanical machining step consisting of shaping the lower surface of the structure (12) (step f) comprises selectively machining the same portions of each of the parts (10) of the batch of metal parts integrated in the mould.
